# DEMANDE DE BREVET EUROPEEN

(11) **EP 1 566 468 A2**
(43) Date de publication de la demande: **24.08.2005**
(21) Numéro de dépôt: 05101204.5
(22) Date de dépôt: 17.02.2005
(51) Int. Cl.: C30B 25/08

(54) **Procédé pour la fabrication de circuits intégrés et dispositif correspondant.**

(30) Priorité: 18.02.2004 FR 0401641
(71) Demandeur: ATMEL NANTES SA, 44306 Nantes Cédex 3 (FR)
(72) Inventeur: Paisant, Laurent, 44850 Saint Mars de Desert (FR)
(74) Mandataire: Bioret, Ludovic

(57) **Abrégé**

L'invention concerne un procédé de fabrication de circuits intégrés comprenant les étapes suivantes :
- conditionnement d'une chambre de dépôt ;
- introduction d'au moins un substrat dans ladite chambre de dépôt ;
- dépôt sur ledit ou lesdits substrats d'un composé ne contenant pas d'oxygène ;
- retrait du ou desdits substrats de ladite chambre de dépôt;
- nettoyage de ladite chambre à l'aide d'un plasma de nettoyage.

Selon l'invention, ladite étape de conditionnement met en oeuvre un dépôt d'un composé de conditionnement contenant au moins un atome d'oxygène, de façon à réagir avec au moins une paroi interne de ladite chambre pour former une couche protectrice sur celle-ci

## Description

Le domaine de l'invention est celui des circuits intégrés et plus précisément de la fabrication de circuits intégrés.

Les circuits intégrés consistent dans de très nombreux transistors et autres composants électroniques regroupés sur une surface réduite. Les espaces entre les différents éléments constituants les circuits sont si faibles que des structures permettant de les isoler sont nécessaires, de façon à éviter les effets parasites.

Les procédés de fabrication de circuits intégrés mettent ainsi en oeuvre un ensemble d'étapes technologiques précises incluant des étapes d'isolation par la réalisation de couches diélectriques inter-métalliques, ainsi que de couches d'encapsulation fmale. L'élément de départ, qu'est le substrat, est composé d'un matériau bien défini, tel que par exemple Si, Ge, GaAs ou InP. A la surface de ces substrats sont déposés des films en couche mince de matériaux particuliers. Après dépôt, le film peut subir des traitements thermiques ou bien un procédé de photolithographie et/ou de gravure. Certaines de ces étapes peuvent être mises en oeuvre plusieurs fois dans les procédés de fabrication.

Une des techniques utilisées pour réaliser le dépôt de films en couche mince est notamment le dépôt chimique en phase vapeur (CVD), et plus particulièrement le dépôt chimique en phase vapeur assisté par plasma, également appelé PECVD pour « Plasma Enhanced Chemical Vapor Deposition ».

Le procédé de fabrication prévoit le dépôt de différents composés, et notamment de nitrure de silicium, à la surface du substrat.

Le principe de dépôt PECVD est la génération d'un plasma à partir d'un mélange gazeux et d'un champ électrique. Les ions du plasma entrent en collision avec les autres molécules du mélange gazeux (contenant par exemple du silane SiH₄ et de l'ammoniac NH₃) et entraîne leur décomposition partielle. Cette dissociation partielle crée des radicaux réactifs (SiHₓ ou NH par exemple) qui réagissent entre eux à la surface du substrat pour former par exemple une chaîne SiₓN_{y} stable. Cette chaîne formera la couche mince de nitrure de silicium Si₃N₄.

Les équipements PECVD connus permettant le dépôt de ces films en couche mince comprennent un réacteur PECVD présentant une chambre de dépôt dont les parois sont réalisées à base d'aluminium et dans laquelle le vide est effectué. La chambre de dépôt est ensuite remplie d'un gaz sous pression réduite et soumise à un champ électrique.

Les équipements PECVD mettent en oeuvre une séquence de fonctionnement, appelée « séquence alpha », se décomposant en la succession d'étape suivante :
- une étape de conditionnement de la chambre de dépôt avec un composé X ;
- une étape d'introduction d'un substrat (également appelé « plaque ») dans la chambre de dépôt ;
- une étape de dépôt d'une couche mince du même composé X sur le substrat (également appelée couche de passivation) ;
- une étape de retrait du substrat de la chambre ;
- une étape de nettoyage de la chambre de dépôt par un plasma de nettoyage.

Selon les techniques de l'art antérieur, le composé utilisé pour le conditionnement de la chambre de dépôt est le même que celui déposé à la surface du substrat. Cela est considéré comme nécessaire, de façon notamment à éviter tout risque de contamination de la chambre.

Dans le cas de dépôts de couches minces de Si₃N₄ (nitrure de silicium), plus particulièrement, le conditionnement de la chambre est réalisé par du nitrure de silicium.

Dans les procédés de fabrication des circuits intégrés, les étapes de conditionnement et de nettoyage de la chambre de dépôt sont indispensables à l'obtention d'une séquence PECVD reproductible quant aux caractéristiques des dépôts réalisés sur les substrats.

En effet, le conditionnement de la chambre avant le dépôt permet d'assurer un état de surface reproductible de la chambre et du support de substrat -ou support de plaque-, cet état de surface contrôlant, entre autres, la conductivité thermique et l'impédance de la chambre de dépôt.

L'étape de nettoyage de la chambre à la fin de chaque séquence de dépôt permet également d'assurer la stabilité du procédé. Les plasmas utilisés pour le nettoyage sont optimisés en fonction du matériau déposé à la surface du substrat, et par rapport à la vitesse de dépôt, aux risques de défaut de densité et à la contrainte mécanique dans les films formés.

Les plasmas utilisés pour le nettoyage sont généralement à base de fluor, comprenant par exemple du tétrafluorure de carbone (CF₄).

Un inconvénient majeur de cette technique de l'art antérieur est la présence d'un dépôt parasite d'AlF₃. Ce dépôt est dû à une réaction se produisant entre l'aluminium présent dans le matériau constituant les parois du réacteur et le fluor du plasma de nettoyage, ce dépôt parasite s'accumulant dans la chambre de dépôt au fur et à mesure de la mise en oeuvre des cycles décrits par la « séquence alpha ».

Un des inconvénients de cette technique est ainsi qu'elle ne permet pas l'obtention de dépôts reproductibles d'un substrat à l'autre. En effet, la présence de ce dépôt parasite modifie notamment l'état de surface de la chambre de dépôt.

Un autre inconvénient de cette technique est qu'elle nécessite de changer fréquemment les pièces du réacteur dégradées par ce dépôt parasite et implique en conséquence des frais de maintenance et de matériel importants.

Un autre inconvénient de cette technique est que le rendement de l'équipement PECVD n'est pas optimum.

L'invention a notamment pour objectif de pallier ces inconvénients de l'art antérieur.

Plus précisément, un objectif de l'invention est de fournir une technique permettant d'éviter la formation d'un dépôt parasite dans la chambre de réaction.

Un autre objectif de l'invention est de fournir une technique permettant la réalisation de dépôts de couches minces d'un composé sur un substrat de façon reproductible.

L'invention a encore pour objectif de permettre la réalisation de dépôts de façon efficace et reproductible (en particulier en ce qui concerne la contrainte mécanique) tout en diminuant les coûts liés à l'entretien de l'équipement PECVD.

Ces objectifs, ainsi que d'autres qui apparaîtront par la suite, sont atteints à l'aide d'un procédé de fabrication de circuits intégrés comprenant les étapes suivantes :
- conditionnement d'une chambre de dépôt ;
- introduction d'au moins un substrat dans ladite chambre de dépôt ;
- dépôt sur ledit ou lesdits substrats d'un composé ne contenant pas d'oxygène ;
- retrait du ou desdits substrats de ladite chambre de dépôt;
- nettoyage de ladite chambre à l'aide d'un plasma de nettoyage.

Selon l'invention, ladite étape de conditionnement met en oeuvre un dépôt d'un composé de conditionnement, différent du composé déposé sur le ou les substrats, contenant préférentiellement au moins un atome d'oxygène, de façon à réagir avec au moins une paroi interne de ladite chambre pour former une couche protectrice sur celle-ci.

Ainsi, l'invention repose sur une approche tout à fait nouvelle et inventive consistant à utiliser un composé contenant de l'oxygène pour conditionner la chambre de dépôt dans les procédés de dépôt de composés ne contenant pas d'oxygène, de façon à former, par réaction avec le matériau dans lequel sont réalisées les parois de la chambre de dépôt, une couche protectrice.

Le demandeur a en effet découvert de façon tout à fait surprenante, que la mise en oeuvre d'un tel procédé permettait d'éviter la formation de dépôts parasites dus à une réaction entre le plasma de nettoyage et les parois de la chambre de dépôt, grâce à la formation d'une couche protectrice sur la surface des parois de la chambre lors de l'étape de conditionnement.

Par ailleurs, le demandeur a observé de façon surprenante que l'utilisation d'un composé différent de celui destiné à être déposé sur les substrats pour conditionner la chambre n'induit pas de contamination de celle-ci (dans la mesure, probablement, où celui-ci réagit avec les parois de la chambre).

Avantageusement, au moins une des parois de la chambre de dépôt comprend de l'aluminium et/ou un alliage d'aluminium et lesdits moyens de nettoyage sont un plasma de nettoyage comprenant un composé fluoré.

De façon préférée, le composé fluoré est du tétrafluorométhane (CF₄).

Préférentiellement, les substrats sur lesquels sont réalisés les dépôts sont une plaque d'un composé choisi parmi Si, Ge, GaAs et InP.

Avantageusement, le composé de conditionnement mis en oeuvre pour le conditionnement de la chambre est l'oxyde de silicium SiO₂.

Ainsi, lors du conditionnement, ce composé réagit avec l'aluminium présent dans les parois de la chambre de dépôt pour former de l'alumine (Al₂O₃). Les parois de la chambre sont alors recouvertes d'une couche protectrice d'alumine et lors du nettoyage de la chambre par le plasma de nettoyage fluoré, il n'y a ainsi pas de formation d'un dépôt parasite d'AlF₃.

En effet, d'une part, le fluor ne réagit presque pas avec la couche superficielle d'alumine car il est très difficile pour les atomes de fluor de prendre la place des atomes d'oxygène dans l'alumine. D'autre part, les atomes de fluor ne peuvent pas pénétrer et traverser la couche d'alumine pour atteindre l'aluminium des parois de la chambre car la couche d'alumine est étanche aux atomes de fluor.

De façon préférée, l'oxyde de silicium est réalisé à partir d'un mélange gazeux de silane et de protoxyde d'azote (N₂O). Le protoxyde d'azote peut également être remplacé par de l'oxygène (O₂).

Avantageusement, le mélange est réalisé à partir d'un flux de silane (SiH₄) présentant un débit de 110 sccm et d'un flux de protoxyde d'azote (N₂O) présentant un débit de 2000 sccm.

De façon avantageuse, le mélange gazeux comprend, en outre, de l'azote N₂ en tant que gaz porteur.

De façon préférée, ladite chambre est soumise à un champ électrique d'une puissance de 400W pendant ladite étape de conditionnement.

Avantageusement, ladite étape de conditionnement est réalisée avec une pression de dépôt de 330 mT et a une durée de 10 s.

De façon avantageuse, le composé ne contenant pas d'oxygène et déposé sur le ou les substrats est le nitrure de silicium (Si₃N₄).

L'invention concerne également un dispositif permettant la mise en oeuvre d'un tel procédé et comprenant au moins un moyen d'acheminement dudit composé de conditionnement contenant de l'oxygène dans ladite chambre de dépôt.

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- la figure 1 présente un synoptique du procédé de fabrication d'un circuit intégré selon l'invention ;
- les figures 2a, 2b, 2c et 2d illustrent les différentes étapes mises en oeuvre par le procédé de fabrication selon la figure 1 ;
- la figure 3 décrit l'évolution de la vitesse de dépôt de Si₃N₄ en fonction du nombre de substrats traités selon la technique de l'art antérieur et selon l'invention ;
- La figure 4 décrit l'évolution de la contrainte mécanique (ou stress) des couches de Si₃N₄ formées sur les substrats selon la technique de l'art antérieur et selon l'invention, en fonction du nombre de substrats traités.

Le principe général de l'invention repose sur le conditionnement de la chambre de dépôt d'un équipement PECVD par un composé contenant de l'oxygène, préalablement au dépôt d'un composé ne contenant pas d'oxygène sur un substrat.

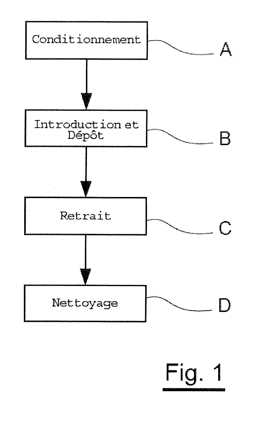

On présente, en relation avec la figure 1, les différentes étapes mises en oeuvre selon un mode de réalisation de l'invention :
- 1^{ère} étape de conditionnement A de la chambre de dépôt, également appelé phase de pré-dépôt, par un composé contenant de l'oxygène, tel que l'oxyde de silicium SiO₂ ;
- 2^{ème} étape d'introduction d'un substrat - ou plaque-, par exemple de silicium, à traiter et de dépôt B sur celui-ci d'une couche d'un composé ne contenant pas d'oxygène, tel que le nitrure de silicium Si₃N₄ ;
- 3^{ème} étape de retrait C de la plaque ainsi traitée ;
- 4^{ème} étape de nettoyage D de la chambre par un plasma de nettoyage fluoré.

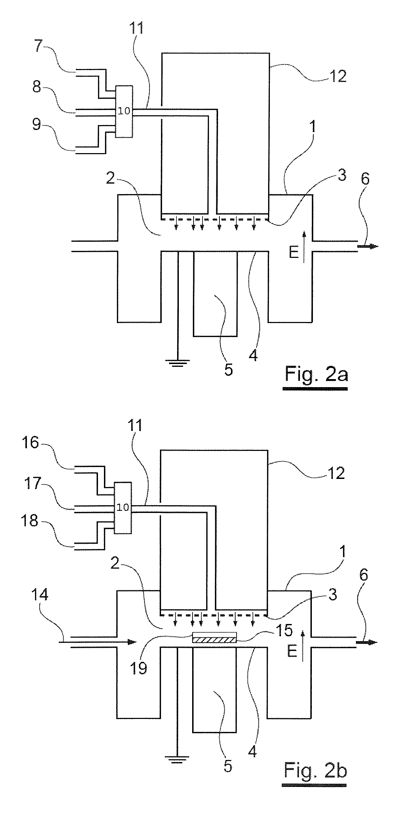

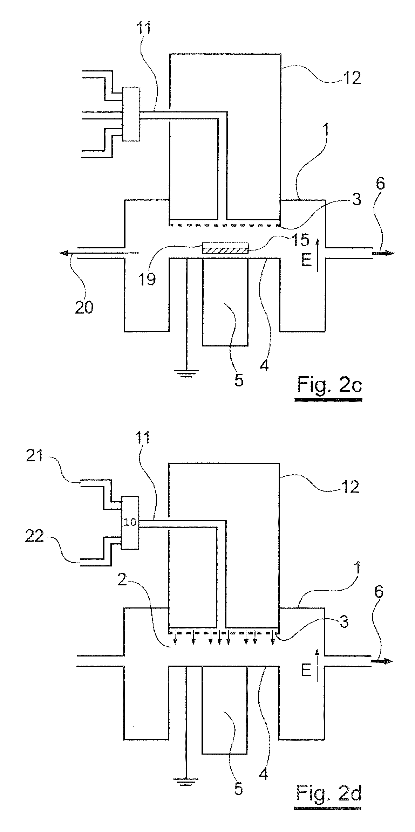

Les figures 2a, 2b, 2c, 2d décrivent respectivement chacune des étapes de la figure 1 de façon plus précise.

La figure 2a illustre l'étape de conditionnement A d'un équipement PECVD comprenant une chambre de dépôt 1 (également appelé réacteur ou chambre de réaction) dont les parois internes sont à base d'aluminium ou d'un alliage d'aluminium. La chambre de dépôt 1 présente une zone de plasma 2 comprise entre une électrode supérieure 3 et une électrode inférieure 4 reliée à la masse, et une source radio-fréquence permettant l'induction un champ électrique E.

Pendant l'étape de conditionnement, le champ électrique E pourra, par exemple, présenter une puissance d'environ 400 W, l'électrode inférieure 4 une température de 250°C et l'électrode supérieure 3, une température de 300°C. Ces valeurs de température des électrodes 3 et 4 pourront être conservées au cours des différentes étapes du procédé.

La chambre de dépôt 1 est sous vide, grâce à une pompe reliée à la chambre au niveau de l'ouverture 6.

Selon ce mode de réalisation, le conditionnement de la chambre de dépôt 1 est réalisé par un pré-dépôt de SiO₂. Les tubes 7 et 8 permettent respectivement l'arrivée de gaz de silane SiH₄ et de protoxyde d'azote N₂O, avec par exemple des débits respectifs de 110 sccm et de 2000 sccm. Le tube 9 permet l'arrivée d'un gaz porteur tel que de l'azote N₂, si la présence de celui-ci est jugée nécessaire.

Les gaz se mélangent au niveau d'un mélangeur 10 et le mélange de gaz est acheminé par un conduit 11 au niveau de la chambre de dépôt 1 en transitant par une chambre 12, également sous vide, de façon à éviter toute réaction entre les différents gaz.

A l'entrée de la chambre de dépôt, un diffuseur de gaz 3 (constituant également l'électrode supérieure) permet de répartir l'arrivée du mélange de gaz de façon homogène dans la zone de plasma 2. Les molécules de gaz s'ionisent alors et réagissent pour former, sur les parois internes de la chambre de dépôt 1, de l'oxyde de silicium, celui-ci réagissant avec l'aluminium présent dans les parois pour former sur celles-ci une couche protectrice d'alumine Al₂O₃.

Le temps de plasma au cours de l'étape de conditionnement pourra par exemple être de l'ordre 10 s et la pression de dépôt de 330 mT.

Il est également envisageable de remplacer le protoxyde d'azote N₂O par de l'oxygène O₂ dans le mélange de gaz pour permettre la formation d'un pré-dépôt de SiO₂.

La figure 2b illustre, consécutivement à l'étape de conditionnement de la chambre, l'étape d'introduction du substrat à traiter et de dépôt B du nitrure de silicium. Typiquement, le substrat pourra être d'une plaque de silicium 15 dont le diamètre est généralement de l'ordre de 100 à 300 mm.

Il est cependant possible d'appliquer cette technique à tout autre substrat, tel que par exemple une plaque d'InP ou d'AsGa.

La plaque de silicium 15 est introduite dans la chambre de dépôt 2 selon la flèche 14 et déposée sur le support de plaque 5 chauffant. Sur les figures 2a, 2b, 2c et 2d, les mêmes références numériques désignent des éléments identiques.

Pendant la phase de dépôt d'une couche mince de nitrure de silicium Si₃N₄, le support de plaque 5 est porté à la même température que l'électrode inférieure 4, typiquement à 250°C. La puissance du champ électrique E pourra être de 500W.

Les flèches 16, 17 et 18 décrivent respectivement les arrivées des gaz de silane SiH₄, d'ammoniac NH₃ et d'azote N₂ comme gaz porteur avec par exemple des débits respectifs de 300 sccm, 700 sccm, et 3500 sccm.

Le mélange de gaz arrive dans la zone de plasma au niveau du diffuseur de gaz 13 pour former, sur la surface de la plaque de silicium, un dépôt de nitrure de silicium 19. Le dépôt formé sur le substrat est également appelé « couche de passivation ».

L'épaisseur de ce dépôt peut varier, et est typiquement de l'ordre de 0,85 à 1,1 µm, avec un temps de plasma de l'ordre de 75 s et une pression de dépôt de 850 mT par exemple.

Il est également envisageable que l'introduction de la plaque à traiter soit faite au moyen du support de plaque, si celui-ci est mobile verticalement, par exemple, ou qu'elle soit introduite par l'entrée 6 par laquelle le vide est crée.

La plaque suivante à traiter pourra, par ailleurs, être placée dans une chambre adjacente à la chambre de dépôt 2, dans laquelle un vide partiel pourra être crée, de façon à ne pas casser totalement le vide dans la chambre de dépôt lors de l'introduction de la plaque.

La figure 2c illustre le retrait C, selon la flèche 20, de la plaque de silicium 15 ainsi traitée de la chambre de dépôt 1.

La chambre de dépôt 1 est ensuite soumise à une étape de nettoyage D, représentée par la figure 2d par un plasma fluoré. Les gaz arrivant par les entrées 21 et 22 sont respectivement du tétrafluorurométhane CF₄ et de l'oxygène O₂ avec par exemple des flux de 400 sccm chacun.

Au cours de l'étape de nettoyage, le temps de plasma pourra être de 75s avec une pression de 850 mT et un champ électrique de 850W, les températures des électrodes 3 et 4 étant inchangées.

Une couche protectrice d'Al₂O₃ ayant été formée sur les parois de la chambre de dépôt 1 lors du conditionnement de la chambre, il n'y a ainsi pas de formation d'un dépôt parasite d'AlF₃ lors de l'étape de nettoyage par le plasma fluoré.

Les différentes arrivées de gaz au cours de différentes étapes pourront évidemment se faire par des entrées différentes, chacun des trois différents mélanges de gaz ainsi mis en oeuvre pouvant être acheminés jusqu'à la chambre de dépôt 1 dans trois conduits différents. Il sera également possible de prévoir un embranchement auquel se rejoignent ces différents conduits et ne prévoir qu'une seule arrivée au niveau du diffuseur de gaz 3 et de la chambre de dépôt 1, l'embranchement pouvant être plus ou moins éloigné de celle-ci.

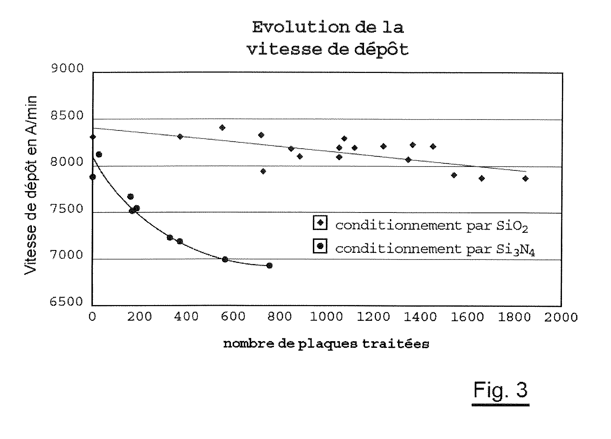

La figure 3 illustre l'évolution de la vitesse de dépôt de Si₃N₄ en fonction du nombre de plaques traitées dans un équipement PECVD.

Une première courbe illustre l'évolution de la vitesse de dépôt selon les conditions des techniques de l'art antérieur, mettant en oeuvre le conditionnement de la chambre de dépôt par Si₃N₄ pour le dépôt ultérieur du même composé sur les plaques. Le conditionnement étant alors effectué dans les mêmes conditions de température des électrodes, de valeur du champ et de pression de dépôt que pour le dépôt de Si₃N₄ sur les plaques de silicium, mais avec un temps de plasma de 10s. On constate une diminution rapide de la vitesse de dépôt au fur et à mesure des plaques traitées.

L'autre courbe résulte des mesures faites selon les conditions du mode de réalisation décrit par les figures 2a, 2b, 2c et 2d, pour lequel le conditionnement est fait avec l'oxyde de silicium.

Ces mesures mettent en évidence une diminution beaucoup moins rapide de la vitesse de dépôt en fonction du nombre de plaques traitées lorsque la chambre de dépôt est conditionnée par SiO₂ préalablement au dépôt de Si₃N₄.

Le dépôt parasite d'AlF₃ dans la chambre de dépôt dans les techniques de l'art antérieur diminue en effet la vitesse de dépôt de Si₃N₄, et implique le changement de plusieurs des pièces de la chambre, altérées par ce dépôt parasite, après le traitement d'un peu plus de 700 plaques seulement (le seuil fixé étant une contrainte mécanique supérieure ou égale à -1.10⁹ dynes/cm²). Lorsque la contrainte mécanique dépasse cette valeur, la couche de passivation se fissure et n'assure donc plus la protection des circuits intégrés.

Dans le cas d'un conditionnement selon l'invention par de l'oxyde silicium, la vitesse de dépôt diminue de façon beaucoup moins importante, et plus de 2500 plaques peuvent être traitées avant de n'avoir à changer des pièces du réacteur.

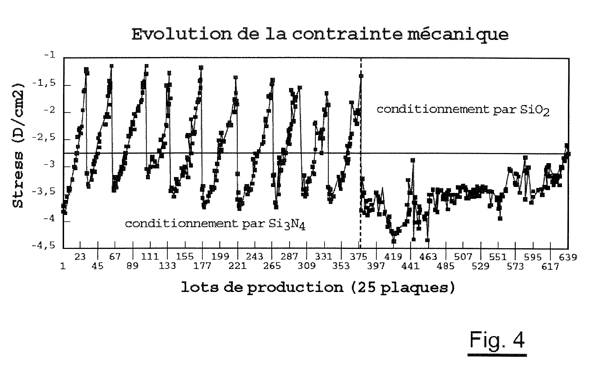

La figure 4 illustre l'évolution de la contrainte mécanique (ou stress) des couches de Si₃N₄ formées en fonction du nombre de lots de plaques traitées, un lot de plaques correspondant à 25 plaques de silicium traitées successivement.

La stabilité et la reproductibilité du procédé de fabrication est en effet indispensable pour l'obtention de circuits intégrés présentant des caractéristiques telles que la contrainte mécanique, identiques. La partie gauche de la courbe illustre le traitement de plaques de silicium selon la technique connue de l'art antérieur, dans laquelle le conditionnement de la chambre de dépôt est effectué par le même composé que celui destiné à être déposé sur les plaques, c'est-à-dire par le nitrure de silicium Si₃N₄.

La courbe illustre ici une variation rapide de la contrainte mécanique des plaques traitées au fur et à mesure des lots de production, chaque rupture de pente correspondant à un changement des pièces du réacteur altérées par le dépôt parasite de AlF₃, celui-ci intervenant à peu près tous les 35 lots de plaques.

La partie droite de la courbe illustre le conditionnement selon l'invention par de l'oxyde de silicium, de façon à empêcher la formation du dépôt parasite d'AlF₃ et montrent une évolution beaucoup plus lente de la contrainte mécanique des plaques de silicium, les pièces de la chambre ne nécessitant effectivement plus d'être changées aussi fréquemment.

Ces résultats, corroborant ceux de la figure 3, montrent que l'invention permet ainsi effectivement de réduire de façon très importante les coûts de maintenance et ceux associés au changement des pièces du réacteur, et qu'elle permet également d'obtenir une meilleur reproductibilité du procédé de fabrication et des caractéristiques des circuits intégrés obtenus par ce procédé.

L'invention permet ainsi également de diminuer la fréquence des contrôles réalisés sur les plaques produites et les coûts associés à ces contrôles.

Le procédé décrit selon ces différents modes de réalisation peut également être mis en oeuvre pour le traitement de plusieurs plaques, de silicium ou d'autres matériaux, simultanément, dans des équipements PECVD prévus pour recevoir plusieurs plaques.

## Revendications

1. Procédé de fabrication de circuits intégrés comprenant les étapes suivantes :
- conditionnement d'une chambre de dépôt ;
- introduction d'au moins un substrat dans ladite chambre de dépôt ;
- dépôt sur ledit ou lesdits substrats d'un composé ne contenant pas d'oxygène ;
- retrait du ou desdits substrats de ladite chambre de dépôt ;
- nettoyage de ladite chambre à l'aide d'un plasma de nettoyage ;
**caractérisé en ce que** ladite étape de conditionnement met en oeuvre un dépôt d'un composé de conditionnement contenant au moins un atome d'oxygène, de façon à ce que ledit composé réagisse avec au moins une paroi interne de ladite chambre pour former une couche protectrice sur celle-ci, la couche protectrice permettant d'éviter la formation d'un dépôt parasite dans la chambre.

2. Procédé selon la revendication 1, **caractérisé en ce qu'**au moins une desdites parois de la chambre de dépôt comprend de l'aluminium et/ou un alliage d'aluminium.

3. Procédé selon l'une quelconque des revendications 1 et 2, **caractérisé en ce que** ledit ledit plasma de nettoyage comprend un composé fluoré.

4. Procédé selon la revendication 3, **caractérisé en ce que** ledit composé fluoré est du tétrafluorométhane (CF₄).

5. Procédé selon l'une quelconque des revendications 1 à 4, **caractérisé en ce qu'**au moins un desdits substrats est une plaque d'un composé choisi parmi Si, Ge, GaAs et InP.

6. Procédé selon l'une quelconque des revendications 1 à 5, **caractérisé en ce que** ledit composé de conditionnement est l'oxyde de silicium (SiO₂).

7. Procédé selon la revendication 6, **caractérisé en ce que** ledit oxyde de silicium est réalisé à partir d'un mélange gazeux de silane (SiH₄) et de protoxyde d'azote (N₂O) ou d'oxygène (O₂).

8. Procédé selon la revendication 7, **caractérisé en ce que** ledit mélange est réalisé à partir d'un flux de silane (SiH₄) présentant un débit de 110 sccm et d'un flux de protoxyde d'azote (N₂O) présentant un débit de 2000 sccm.

9. Procédé selon l'une quelconque des revendications 7 et 8, **caractérisé en ce que** ledit mélange gazeux comprend, en outre, de l'azote (N₂).

10. Procédé selon l'une quelconque des revendications 1 à 9, **caractérisé en ce que**, pendant ladite étape de conditionnement, ladite chambre est soumise à un champ électrique d'une puissance de 400W.

11. Procédé selon l'une quelconque des revendications 1 à 10, **caractérisé en ce que** ladite étape de conditionnement est réalisée avec une pression de dépôt de 330 mT.

12. Procédé selon l'une quelconque des revendications 1 à 11, **caractérisé en ce que** ladite étape de conditionnement a une durée de sensiblement 10 s.

13. Procédé selon l'une quelconque des revendications 1 à 12, **caractérisé en ce que** ledit composé déposé sur le ou lesdits substrats est le nitrure de silicium (Si₃N₄).

14. Dispositif pour la fabrication de circuits intégrés comprenant :
- une chambre de dépôt prévue pour recevoir au moins un substrat ;
- des moyens de conditionnement de ladite chambre de dépôt;
- des moyens de dépôt d'au moins une couche d'un composé ne contenant pas d'oxygène sur ledit substrat ; et
- des moyens de nettoyage de ladite chambre de dépôt à l'aide d'un plasma de nettoyage après le retrait dudit substrat ;
**caractérisé en ce qu'**il comprend au moins un moyen d'acheminement dans ladite chambre de dépôt d'un composé de conditionnement contenant au moins un atome d'oxygène, de façon à ce que ledit composé réagisse avec au moins une paroi interne de ladite chambre pour former une couche protectrice sur celle-ci, la couche protectrice permettant d'éviter la formation d'un dépôt parasite dans la chambre.
